# DEMANDE DE BREVET EUROPEEN

(11) **EP 0 577 484 A1**
(43) Date de publication de la demande: **05.01.1994**
(21) Numéro de dépôt: 93401643.7
(22) Date de dépôt: 25.06.1993
(51) Int. Cl.: C04B 37/02, H01S 3/025, C04B 41/00

(54) **Procédé pour réaliser une liaison entre du cuivre et un substrat pour l'électronique de puissance en céramique non oxyde**

(30) Priorité: 29.06.1992 FR 9207964
(71) Demandeur: ALCATEL ALSTHOM COMPAGNIE GENERALE D'ELECTRICITE, F-75382 Paris Cédex 08 (FR)
(72) Inventeur: Queriaud, Roland c/o Alcatel Alsthom Recherche, F-91460 Marcoussis (FR); Petitbon, Alain, F-78730 St Arnoult en Yvelines (FR)
(74) Mandataire: Laroche, Danièle

(57) **Abrégé**

Procédé pour réaliser une liaison entre du cuivre et un substrat pour l'électronique de puissance conducteur de la chaleur et électriquement isolant en céramique non oxyde, procédé consistant à oxyder superficiellement ledit substrat et à utiliser ensuite la technique DBC (Direct Bond Copper), caractérisé par le fait que l'opération d'oxydation superficielle dudit substrat est effectuée en irradiant la surface concernée à l'aide d'un faisceau laser suivant une épaisseur comprise entre 0,1 µm à 3 µm.

## Description

La présente invention concerne un procédé pour réaliser une liaison entre du cuivre et un substrat pour l'électronique de puissance en céramique non oxyde, procédé utilisant la technologie communément appelée DBC (Direct Bond Copper). Pour les applications visées, ladite céramique non oxyde est conductrice de la chaleur et électriquement isolante. Elle est choisie par exemple parmi BN, SiC, AlN...

La technologie DBC a été utilisée pour lier du cuivre à l'alumine Al₂O₃ dans l'industrie électronique (cf J.F. Burgess et al, "Hybrid Packages by the direct Bond Copper Process" Solid State Science and Technology, May 1975, pp 40).

Cette technique est très avantageuse puisqu'elle permet de lier le cuivre à l'oxyde sans l'emploi d'une couche intermédiaire (brasure par exemple) qui, en général, réduit le transfert thermique. Elle est basée sur la formation d'un eutectique cuivre-oxygène à 1065°C, comme indiqué dans les deux articles suivants :
- J.F. Dickson, "Direct Bond Copper Technology : materials, methode, applications", Int. J. Hybrid Microelectronic, 5(2), 103-109 (1982)
- J.E. Holowczak, V.A. Greenhut, O.J. Shanefield, "Effect of alumina composition on Interfacial Chemestry and strength of Direct Bonded Copper-Alumina", Ceram. Eng. Sci. Proc. 10 [9-10], pp 1283-1294 (1989).

Le cuivre est placé en contact sur la céramique et l'ensemble est chauffé jusqu'à une température comprise entre 1065°C (température de l'eutectique) et 1083°C (température de fusion du cuivre) dans une atmosphère inerte. L'oxygène nécessaire à la formation de l'eutectique peut être introduit directement dans l'atmosphère ou bien être apporté par une oxydation préalable du cuivre. A la température de traitement, le liquide formé mouille à la fois la céramique et le cuivre, formant après refroidissement une liaison entre les deux antagonistes. Un aluminate de cuivre est aussi formé, renforçant l'adhérence du cuivre.

Bien que cette technique se soit jusqu'à présent appliquée essentiellement à l'alumine, on sait qu'elle permet aussi de lier le cuivre à la silice, à l'oxyde de beryllium (BeO), au saphir ou à certains composés de type spinelle, tous ces matériaux étant des oxydes.

Les nouvelles céramiques à haute conductivité thermique pour l'électronique de puissance, comme le nitrure d'aluminium (AlN) par exemple, ne peuvent être liées au cuivre par cette technique que si elles sont préalablement oxydées en surface. En effet, les non-oxydes (comme AlN) ne sont pas mouillés par le cuivre ou par l'eutectique Cu-O, et la formation d'aluminate de cuivre n'est pas possible.

L'oxydation superficielle du nitrure d'aluminium en alumine est un paramètre important qui conditionne la qualité de l'accrochage du cuivre au nitrure d'aluminium, comme l'indiquent la demande de brevet européen EP-A-170012 et les deux articles suivants :
- P. Kluge-Weiss, J. Gobrecht, "Direct Bonded Copper Metallization of AlN substrates for Power Hybrids" Mat. Res. Soc. Symp. Proc. 40 (1985)
- W.L. Chiang, V.A. Greenhut, D.J. Shanefield, L. Sahati, R.L. Moore, "Effect of Substrate and Pretreatment on copper to AlN direct Bonds". Ceram. Eng. Sci. Proc. 12 [9-10] pp 2105-2114 (1991).

En particulier, une épaisseur trop importante de la couche d'alumine formée entraîne des contraintes entre AlN et Al₂O₃ et donc abaisse la qualité de la liaison ultérieure Cu-AlN. L'épaisseur de la couche d'oxyde doit être la plus faible possible mais doit cependant rester suffisante car cette couche se trouve complètement dissoute sur une épaisseur inférieure à 0,1 µm dans l'eutectique Cu-O.

Jusqu'à présent l'oxydation du nitrure est réalisée dans un four sous air ou sous oxygène à des températures supérieures à 1100°C pendant des temps supérieurs à 1 heure. Le procédé est long et il ne permet pas la réalisation d'une oxydation sélective à des endroits précis de la surface du nitrure d'aluminium. D'autre part ce procédé ne peut pas être appliqué aux couches de nitrure d'aluminium minces ou épaisses supportées par des substrats oxydables.

La présente invention a pour but de réaliser de manière plus précise et plus rapide l'oxydation superficielle du substrat en céramique non oxyde, afin de pouvoir le lier aisément ensuite à un élément en cuivre par la technique DBC.

La présente invention a pour objet un procédé pour réaliser une liaison entre du cuivre et un substrat pour l'électronique de puissance, conducteur de la chaleur et électriquement isolant, en céramique non oxyde choisie parmi AlN, SiC, BN, procédé consistant à oxyder superficiellement ledit substrat et à utiliser ensuite la technique DBC (Direct Bond Copper), caractérisé par le fait que l'opération d'oxydation superficielle dudit substrat est effectuée en irradiant la surface concernée à l'aide d'un faisceau laser suivant une épaisseur comprise entre 0,1 µm à 3 µm.

Grâce à ce procédé, seule la zone concernée par la liaison DBC est donc soumise au traitement d'oxydation, et ceci suivant une épaisseur contrôlable.

Ledit laser peut être un laser continu ou pulsé, choisi parmi un laser excimère, un laser YAG, et de préférence un laser CO₂.

Avantageusement ledit faisceau laser est un faisceau infrarouge continu, de diamètre compris entre 0,5 mm et 10 mm, avec une puissance comprise entre 50 watts et 3 Kwatts, la durée du traitement étant comprise entre 1 ms et 3 secondes.

La zone traitée est ainsi délimitée avec une grande précision et le traitement est très rapide.

On peut opérer sous air, mais de préférence, l'on envoie sur la surface traitée un flux gazeux d'oxygène, coaxialement audit faisceau laser.

De préférence, ledit faisceau laser est homogénéisé, par exemple avec un kaléïdoscope.

Le diamètre du faisceau précédemment défini peut être ajusté par un dispositif optique de focalisation.

Afin d'éviter tout risque de dégradation, en particulier par fissuration de la couche d'oxyde obtenue par le traitement selon l'invention, il peut être avantageux dans certains cas, préalablement à ladite opération d'oxydation superficielle dudit substrat, de préchauffer ce dernier jusqu'à une température de l'ordre de 200°C à 600°C.

Ce préchauffage, réalisé par exemple simplement par l'intermédiaire de résistances, peut réduire les chocs thermiques néfastes.

Dans tout ce qui précède le substrat en céramique nonoxyde peut se présenter sous la forme d'une couche mince ou d'une couche épaisse disposée sur un support quelconque qui n'est alors pas du tout affecté par le traitement d'oxydation selon l'invention.

D'autres caractéristiques et avantages de la présente invention apparaîtront au cours de la description suivante d'un mode de réalisation donné à titre illustratif mais nullement limitatif.

On part d'un substrat en nitrure d'aluminium d'épaisseur 1,5 mm. On réalise un préchauffage par l'intermédiaire d'une résistance placée au-dessous du substrat ; la température atteinte est de 400°C.

On envoie, perpendiculairement à la surface du substrat à traiter, un flux d'oxygène avec un débit de 3 m³/heure.

Le faisceau mis en oeuvre est issu d'un laser continu CO₂ de puissance 1700 watts ; il est homogénéisé par un kaléidoscope de façon que le spot destiné au traitement du substrat présente une section carrée, de côté sensiblement égal à 5 mm. Avec un temps de traitement de 1 seconde on obtient une oxydation superficielle homogène sur une épaisseur sensiblement égale à 0,5 µm.

Bien entendu, l'invention n'est pas limitée à ce mode de réalisation ; en particulier elle s'applique aux autres céramiques non oxydes.

## Revendications

**1/** Procédé pour réaliser une liaison entre du cuivre et un substrat pour l'électronique de puissance conducteur de la chaleur et électriquement isolant en céramique non oxyde choisie parmi AlN, SiC, BN, procédé consistant à oxyder superficiellement ledit substrat et à utiliser ensuite la technique DBC (Direct Bond Copper), caractérisé par le fait que l'opération d'oxydation superficielle dudit substrat est effectuée en irradiant la surface concernée à l'aide d'un faisceau laser suivant une épaisseur comprise entre 0,1 µm à 3 µm.

**2/** Procédé selon la revendication 1, caractérisé par le fait que ledit laser est choisi parmi les lasers continus, les lasers pulsés, à excimère, à YAG, à CO₂.

**3/** Procédé selon la revendication 1, caractérisé par le fait que ledit faisceau laser est un faisceau infrarouge continu, de diamètre compris entre 0,5 mm et 10 mm, avec une puissance comprise entre 50 watts et 3 Kwatts, la durée du traitement étant comprise entre 1 ms et 3 secondes.

**4/** Procédé selon l'une des revendications 2 et 3, caractérisé par le fait que l'on envoie sur la surface traitée un flux gazeux d'oxygène, coaxialement audit faisceau laser.

**5/** Procédé selon l'une des revendications 2 à 4, caractérisé par le fait que ledit faisceau laser est homogénéisé.

**6/** Procédé selon l'une des revendications 1 à 5, caractérisé par le fait que, préalablement à ladite opération d'oxydation superficielle dudit substrat, ce dernier est préchauffé jusqu'à une température de l'ordre de 200°C à 600°C.
